Europäisches Patentamt

European Patent Office

Office européen des brevets

(11) Publication number: **0 242 125**
**A2**

## (12) EUROPEAN PATENT APPLICATION

(21) Application number: **87303084.5**

(22) Date of filing: **09.04.87**

(51) Int. Cl.⁴: **H03B 5/32**

(30) Priority: **16.04.86 JP 87642/86**

(43) Date of publication of application:
**21.10.87 Bulletin 87/43**

(84) Designated Contracting States:
**DE FR GB**

(71) Applicant: **SEIKO INSTRUMENTS INC.**
**31-1, Kameido 6-chome Koto-ku**
**Tokyo 136(JP)**

(72) Inventor: **Hattori, Yoshio SEIKO**
**INSTRUMENTS INC.**
**31-1, Kameido 6-chome**
**Tokyo(JP)**

(74) Representative: **Caro, William Egerton et al**
**J. MILLER & CO. Lincoln House 296-302 High**
**Holborn**
**London WC1V 7JH(GB)**

(54) **Oscillation circuit for a piezo-electric resonator and method of controlling same.**

(57) An oscillation circuit including a piezo-electric resonator (4) and a semi-conductor variable capacitance element (6) for controlling the frequency of oscillation of the resonator. The semiconductor variable capacitance element is such that its capacitance is controlled by electric charge stored in a floating electrode insulated from the exterior by an insulating film formed on the surface of a semiconductor substrate. A terminal (14) is arranged so that a bias voltage can be applied to a capacitor electrode of the semiconductor variable capacitance element.

# FIG. 1

## "OSCILLATION CIRCUIT FOR A PIEZO-ELECTRIC RESONATOR AND METHOD OF CONTROLLING SAME"

This invention relates to oscillation circuits for piezo-electric resonators and methods of controlling same.

A semiconductor variable capacitance element is disclosed in Proceedings Vol. 2 in the 11th International Congress of Chronometry, edited by The French Society of Microtechnology and Chronometry, page 9, 1984.

Figure 2 is a diagram illustrating a conventional CMOS quartz oscillation circuit employing a semiconductor variable capacitance element. A feedback resistor 22 is connected between the gate and the drain of an inverter 21. A drain resistor 23 and a quartz resonator 24 are connected in series between the gate and the drain of the inverter 21. To one end of the quartz resonator 24 is connected a drain capacitor 25 and to the other end is connected a semiconductor variable capacitance element 26 for adjusting the oscillation frequency. A power source 28 is applied to the inverter 31 through a constant voltage circuit or a constant current circuit 27. Thus the quartz oscillation circuit consumes a reduced amount of electric current, and the oscillation frequency is unaffected by change of voltage of the power source. The oscillation frequency is adjusted by changing the capacitance of the semiconductor variable capacitance element 26 relying upon electric charge stored in a floating electrode thereof. Therefore, the capacitance of the semiconductor variable capacitance element 26 can be easily varied, and consequently the oscillation frequency can be correctly adjusted, thereby maintaining very high reliability.

In the conventional CMOS quarts oscillation circuit shown in Figure 2, the frequency is adjusted by changing the capacitance of the semiconductor variable capacitance element 26. Change of capacitance, however, requires positive and negative voltages of in excess of 10 volts. Furthermore, it is difficult, after adjustment, to return the frequency to that before adjustment.

According to one aspect of the present invention there is provided an oscillation circuit including a piezo-electric resonator and a semi-conductor variable capacitance element for controlling the frequency of oscillation of the resonator, the semiconductor variable capacitance element being such that its capacitance is controlled by electric charge stored in a floating electrode insulated from the exterior by an insulating film formed on the surface of a semi-conductor substrate, characterised by biasing means for applying a bias voltage to a capacitor electrode of the semiconductor variable capacitance element.

In one embodiment the biasing means comprises a power source.

The biasing means may include a resistance network for producing the bias voltage.

According to a further aspect of the present invention there is provided a method of controlling an oscillation circuit according to the present invention where the charge stored in the floating electrode corresponds to a given temperature, deviation of frequency of the oscillation circuit caused by change of temperature from said given temperature being corrected by said bias voltage.

The invention is illustrated, merely by way of example, in the accompanying drawings, in which:-

Figure 1 is a circuit diagram illustrating a first embodiment of an oscillation circuit according to the present invention for a piezo-electric resonator;

Figure 2 is a diagram illustrating a conventional quartz oscillation circuit; and

Figure 3 is a circuit diagram illustrating a second embodiment of an oscillation circuit according to the present invention for a piezo-electric resonator.

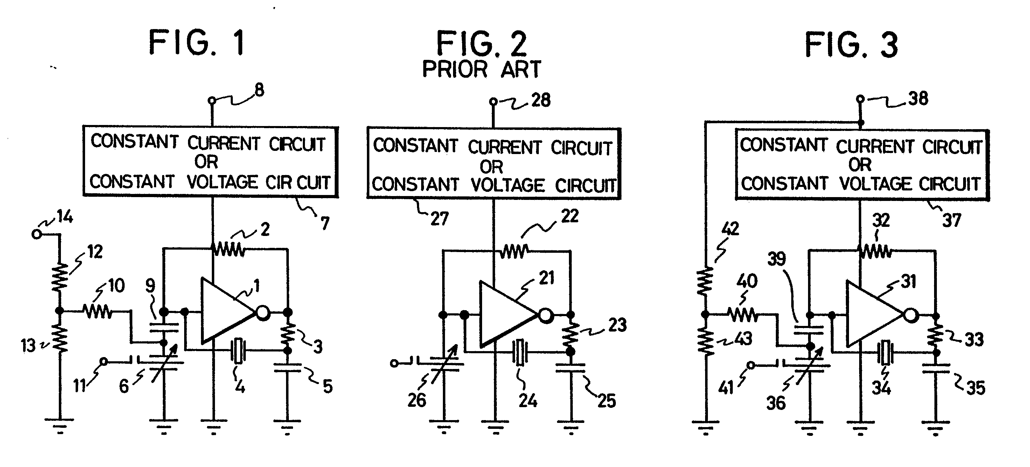

Figure 1 is a diagram which illustrates an oscillation circuit according to the present invention. A feedback resistor 2 is connected between the gate and drain of a CMOS inverter 1. A drain resistor 3 and a quartz resonator 4 are connected in series between the gate and drain of the inverter. Further, a drain capacitor 5 is connected to a terminal on the drain side of the quartz resonator 4, and a semiconductor variable capacitance element 6 is connected to a terminal on the gate side of the quartz resonator via a DC cut capacitor 9. The semiconductor variable capacitance element 6 is used to adjust the frequency of the oscillation circuit. A constant voltage circuit or a constant current circuit 7 is connected between the inverter 1 and a power source 8. Therefore, the oscillation circuit consumes a reduced amount of electric current, and the oscillation frequency is unaffected by change of voltage of the power source. One side of a RF cut resistor 10 is connected to a capacitor electrode of the semiconductor variable capacitance element 6, and the other side is connected via a dividing resistor 12 to a bias terminal 14 which receives an external bias voltage. The dividing resistor 12 together with a dividing resistor 13 forms a resistance network to control the change of capacitance of the semiconductor variable capacitance element by dividing the bias voltage applied to the bias terminal 14. In principle, therefore, the dividing resistors are not essential.

A variable terminal 11 of the semiconductor variable capacitance element 6 controls the amount of electric charge stored in a floating electrode of the semiconductor variable capacitance element 6. If a high voltage pulse of either positive polarity or negative polarity is applied to the variable terminal 11, a tunnel current flows into a very thin oxide film between the floating electrode and the variable terminal 11 provided in the semiconductor variable capacitance element 6, making it possible to change the amount of electric charge stored in the floating electrode. The potential of the floating electrode depends on the charge stored in the floating electrode whereby the capacitance of the depletion layer also changes on the surface of the semiconductor substrate under the floating electrode in the semiconductor variable capacitance element 6. Since the floating electrode is covered by an oxide film having excellent insulating properties, the amount of electric charge that is stored does not change with the lapse of time unless a variable voltage pulse is applied to the variable terminal 11. Therefore, the capacitance between a substrate and a capacitor electrode of the semiconductor variable capacitance element 6 can be changed at will dependent upon the amount of electric charge stored in the floating electrode.

Further, the floating electrode and capacitor electrode of the semiconductor variable capacitance element 6 are firmly capacitance coupled together, and the potential of the floating electrode is seriously affected by the voltage of the capacitor electrode. The capacitance varies depending upon the potential of the floating electrode in the semiconductor variable capacitance element 6, and, hence, the capacitance of the semiconductor variable capacitance element changes with the bias voltage applied to the bias terminal 14. The voltage applied to the capacitor electrode of the semiconductor variable capacitance element 6 changes with the bias voltage applied to the bias terminal 14 and the potential of the floating electrode in the semiconductor variable capacitance element 6 changes depending upon the voltage of the capacitor electrode. Therefore, the capacitance of the semiconductor variable capacitance element 6 changes.

The frequency of the oscillation circuit changes depending upon the capacitance connected to the gate of the inverter 1. Therefore, the frequency of the oscillation circuit shown in Figure 1 can be changed by applying variable voltage pulses of either positive polarity or negative polarity to the variable terminal 11 or by varying the bias voltage applied to the bias terminal 14.

The absolute value of the frequency of the oscillation circuit is adjusted by applying a constant bias voltage to the bias terminal 14 and by applying a variable voltage pulse to the variable terminal 11 of the semiconductor variable capacitance element 6. By applying the variable voltage pulse to the variable terminal 11 of the semiconductor variable capacitance element 6, it is possible to control very precisely the electric charge stored in the floating electrode of the semiconductor variable capacitance element 6. Further, the electric charge once stored in the floating electrode remains very stable, and the amount of electric charge does not change for more than ten years. Moreover, the amount of electric charge does not change even when the power source of the oscillation circuit is turned off.

The frequency of the oscillation circuit, on the other hand, can be relatively or temporarily adjusted by changing the bias voltage applied to the bias terminal 14. The bias voltage applied to the bias terminal 14 is as small as 5 volts or less, and is easily generated by, for example, a DA converter incorporated in the same IC as the oscillation circuit. Furthermore, the oscillation frequency can be very easily varied since it is controlled by the voltage. Two oscillation frequencies are obtained by returning the bias voltage that serves as a reference and that was once changed again to a bias voltage that serves as the reference, i.e. by forming two bias voltages and electrically switching these bias voltages. Thus the two frequencies are easily obtained by a switching operation.

Therefore, a method of changing the bias voltage applied to the bias terminal 14 is adapted to relatively or temporarily adjust the frequency of the oscillation circuit.

Figure 3 is a diagram illustrating an oscillation circuit according to a second embodiment of the present invention. A feedback resistor 32 is connected between the gate and drain of a CMOS inverter 31, and a quartz resonator 34 is also connected between the gate and the drain via a drain resistor 33. Further, a drain capacitor 35 is connected to a terminal of the quartz resonator 34 on the drain side, and a semiconductor variable capacitance element 36 for adjusting the oscillation frequency is connected to a terminal on the gate side via a DC cut capacitor 39. A constant voltage circuit or constant current circuit 37 is connected between the inverter 31 and the power source, and the oscillation circuit consumes a reduced amount of electric current. The common connection of dividing resistors 42 and 43 forming a resistance network is connected to a capacitor electrode of the semiconductor variable capacitance element 36. A power source voltage 38 of the oscillation circuit is applied as a bias voltage to the capacitor electrode of the semiconductor variable capacitance element 36 via a RF cut resistor 40.

The oscillation circuit of Figure 3 is adjusted in the same manner as in the first embodiment shown in Figure 2 by maintaining the power source voltage 38 of the oscillation circuit constant and by applying a variable voltage pulse to the variable terminal 41 of the semiconductor variable capacitance element 36. Further, the bias voltage applied via the dividing resistor 42 and the RF cut resistor 40 to the capacitor electrode of the semiconductor variable capacitance element 36 changes with the change in the power source voltage of the oscillation circuit and, hence, the capacitance of the semiconductor variable capacitance element 36 changes. By changing the power source voltage 38 of the oscillation circuit, the frequency of the oscillation circuit can be changed relatively or temporarily. The sensitivity of frequency relative to the power source voltage can be adjusted by suitably selecting the ratio of the dividing resistors 42, 43.

If a CMOS is employed in the oscillation circuit of Figure 3, a reduced amount of electric current is consumed. This makes it possible to connect an analog output terminal of a DA converter having a small current output capacity to the power source voltage 38 of the oscillation circuit.

Furthermore, the frequency can be adjusted at normal temperatures using the variable terminal 11 of the semiconductor variable capacitance element 6, and the frequency can also be easily adjusted relying upon the temperature characteristics of the quartz resonator 4 using the bias terminal 14.

The present invention employs, as a capacitor for adjusting frequency, a semiconductor variable capacitance element which has a bias terminal to apply a predetermined bias voltage to a capacitor electrode of the semiconductor variable capacitance element. A reference frequency that must be stored even when the power source is turned off is set by changing the amount of electric charge stored in the floating electrode of the semiconductor variable capacitance element. Further, a bias voltage applied to the capacitor electrode is varied in order to change temporarily or relatively the frequency. The bias voltage applied to the capacitor electrode is as low as 5 volts or less. Further, since the bias voltage needs to have either a positive polarity or a negative polarity, the power source voltage of the oscillation circuit can be used as a bias voltage. Here, the positive polarity or negative polarity of the bias voltage is determined depending on the type (p-type or n-type) of the substrate of the semiconductor variable capacitance element.

The frequency that serves as a reference can be adjusted highly precisely and highly reliably. Further, when the frequency is to be temporarily changed or is to be relatively changed without affecting the frequency that serves as the reference, the voltage necessary for controlling the frequency can be easily confined within a voltage range that is usually used for the TTL.

Further, since the bias voltage applied to the bias terminal changes with change in the power source voltage of the oscillation circuit, the frequency of the oscillation circuit can be also changed by changing the power source voltage of the oscillation circuit.

According to the present invention, as will be appreciated from the foregoing description, provision is made for a bias terminal to apply a bias voltage from the exterior to the capacitor electrode of the semiconductor variable capacitance element in order to adjust the frequency of the oscillation circuit which employs a piezo-electric resonator. Therefore, the frequency can be changed not only by the amount of electric charge stored in the floating electrode of the semiconductor variable capacitance element but also by the bias voltage. Based upon these two means for adjusting frequency, the absolute value of the frequency that serves as a reference can be adjusted precisely and highly reliably. Without affecting the absolute value, the frequency can be changed temporarily or relatively and very easily using a voltage that is used for an ordinary TTL.

## Claims

1. An oscillation circuit including a piezo-electric resonator (4; 34) and a semi-conductor variable capacitance element (6; 36) for controlling the frequency of oscillation of the resonator, the semiconductor variable capacitance element being such that its capacitance is controlled by electric charge stored in a floating electrode insulated from the exterior by an insulating film formed on the surface of a semi-conductor substrate, characterised by biasing means (10, 12, 13, 14; 38, 40, 42, 43) for applying a bias voltage to a capacitor electrode of the semiconductor variable capacitance element.

2. An oscillation circuit as claimed in claim 1 characterised in that the biasing means comprises a power source (38).

3. An oscillation circuit as claimed in claim 1 or 2 characterised in that the biasing means includes a resistance network (12, 13; 42, 43) for producing the bias voltage.

4. A method of controlling an oscillation circuit as claimed in any preceding claim characterised in that the charge stored in the floating electrode corresponds to a given temperature, deviation of frequency of the oscillation circuit caused by change of temperature from said given temperature being corrected by said bias voltage.

5. In an oscillation circuit for a piezo-electric resonator employing a semiconductor variable capacitance element of which the capacitance is controlled by an electric charge stored in a floating electrode that is insulated from an external side being covered by an insulating film which is formed on the surface of a semiconductor substrate, an electronic circuit characterized in that the frequency of the oscillation circuit for said piezo-electric resonator is controlled by an electric charge stored in the floating electrode of said semiconductor variable capacitance element, and is also controlled by a bias voltage applied to a capacitor electrode of said semiconductor variable capacitance element.

6. An electronic circuit according to claim 5, wherein said frequency is adjusted by the electric charge stored in the floating electrode of said semiconductor variable capacitance element at a particular temperature, and the change of frequency caused by the temperature characteristics of said piezo-electric resonator is corrected by said bias voltage.

# FIG. 1

CONSTANT CURRENT CIRCUIT
OR
CONSTANT VOLTAGE CIRCUIT

# FIG. 2
PRIOR ART

CONSTANT CURRENT CIRCUIT
OR
CONSTANT VOLTAGE CIRCUIT

# FIG. 3

CONSTANT CURRENT CIRCUIT
OR
CONSTANT VOLTAGE CIRCUIT

0 242 125